# EUROPÄISCHE PATENTSCHRIFT

(11) **EP 2 941 822 B1**
(45) Veröffentlichungstag und Bekanntmachung des Hinweises auf die Patenterteilung: **24.08.2022**
(21) Anmeldenummer: 13707358.1
(22) Anmeldetag: 28.02.2013
(51) Int. Cl.: H02M 7/00, H02M 7/10

(54) **UMRICHTERSTATION MIT DIODENGLEICHRICHTER**
CONVERTER STATION WITH DIODE RECTIFIER
POSTE DE CONVERSION ÉQUIPÉ D'UN REDRESSEUR À DIODES

(43) Veröffentlichungstag der Anmeldung: 11.11.2015
(73) Patentinhaber: Siemens Energy Global GmbH & Co. KG, 81739 München (DE)
(72) Erfinder: DORN, Jörg, 96155 Buttenheim (DE); ERGIN, Dominik, 91083 Baiersdorf (DE); HAMMER, Thomas, 91126 Schwabach (DE); KNAAK, Hans-Joachim, 91054 Erlangen (DE); MENKE, Peter, 96237 Oberfüllbach (DE); SCHUSTER, Roland, 91056 Erlangen (DE)
(86) Internationale Anmeldenummer: PCT/EP2013/054061
(87) Internationale Veröffentlichungsnummer: WO 2014/131456

(56) Entgegenhaltungen:
- EP-A1- 1 198 058
- WO-A1-2012/175112
- US-A- 4 441 150
- US-A1- 2008 074 074
- US-A1- 2012 020 463
- US-A1- 2012 057 308

## Beschreibung

Die Erfindung betrifft eine Umrichterstation zum Übertragen elektrischer Leistung mit einem Umrichter, der einen Gleichspannungsanschluss und einen Wechselspannungsanschluss aufweist, und mit wenigstens einem Transformator, der mit dem Wechselspannungsanschluss verbundenen ist, wobei der Transformator und der Umrichter in einem Isolierstoff angeordnet sind.

Eine solche Umrichterstation ist beispielsweise aus dem Artikel von S. Bernal-Perez et al., "Windpower plant control for the connection to multiterminal HVDC links", IEEE, 2012, Seite 2873 bekannt. Dort ist eine Anlage offenbart, bei der ein Diodengleichrichter gleichspannungsseitig mit einem Gleichspannungszwischenkreis verbunden ist. Der Gleichspannungszwischenkreis erstreckt sich zwischen zwei spannungseinprägenden Umrichtern, die im Englischen auch als "Voltage Source Converter (VSC)" bezeichnet werden. Der Diodengleichrichter ist über Transformatoren und einem Wechselspannungsnetz mit einem Windpark verbunden. Darüber hinaus sind Filtereinheiten offenbart, die wechselspannungsseitig des Umrichters angeordnet sind. Gleichspannungsseitig dient eine Glättungsdrossel zum Glätten des vom Diodengleichrichter erzeugten Gleichstromes.

Aus der DE 2 316 327 A ist eine Umrichterstation mit einem Thyristor-Gleichrichter bekannt, der in einem mit Öl befüllten Kapselungsgehäuse angeordnet ist.

Aus der US 2012/0020463 A1 ist eine Hochspannungs-Stromversorgungseinrichtung zur Versorgung beispielsweise einer Röntgenröhre bekannt. Diese Stromversorgungseinrichtung weist eine Mehrzahl von Spannungsvervielfachern auf, die jeweils mittels eines Ringspulentransformators an einen gemeinsamen Wechselspannungsleiter angekoppelt sind.

Die Schrift US 4,441,150 A offenbart eine Hochspannungs-Gleichrichtereinheit. Diese Hochspannungs-Gleichrichtereinheit weist ein Gehäuse auf, das mit einer elektrisch isolierenden Flüssigkeit gefüllt ist. Im Inneren des Gehäuses sind ein Transformator und Gleichrichtelemente angeordnet.

Aus der Offenlegungsschrift EP 1 198 058 A1 ist eine elektronische Konverterschaltung bekannt. Bei dieser Konverterschaltung sind Spulen und Halbleiter-Schaltelemente in einer Substanz mit einer hohen thermischer Leitfähigkeit und mit guten elektrischen Isolationseigenschaften eingegossen.

Die Schrift WO 2012/175112 A1 offenbart ein Gehäuse mit im Inneren des Gehäuses angeordneten Leistungshalbleitern. Das Gehäuse weist Anschlüsse auf, die mit den Leistungshalbleitern elektrisch verbunden sind. Mittels einer Überbrückungseinrichtung können die in dem Gehäuse angeordneten Leistungshalbleiter elektrisch überbrückt werden.

Die US 2008/0074074 A1 offenbart eine elektrische Schaltung zur Stromversorgung eines Motors. Diese Schaltung weist eine Filterspule und einen Transformator auf. Die Filterspule und der Transformator sind in einem ölgefüllten Gehäuse angeordnet.

Aus der Offenlegungsschrift US 2012/0057308 A1 ist eine Anordnung mit einem Konverter zur Stromversorgung einer auf dem Meer befindlichen elektrischen Last mittels einer Hochspannungsgleichstromübertragung bekannt. Dabei wird wird von einem landseitigen Energieversorgungsnetz gelieferter Wechselstrom mittels eines landseitigen Gleichrichters gleichgerichtet, über eine Hochsspannungsgleichstromleitung zu einem meerseitigen Wechselrichter übertragen und von diesem wieder in Wechselstrom gewandelt. Mit dem Wechselstrom wird eine meerseitige Last versorgt.

Die Anbindung von im Meer aufgestellten Windparks an ein landseitiges Versorgungsnetz kann bei großen Übertragungsstrecken ökonomisch nur mit Hilfe von Gleichstrom erfolgen. Aus diesem Grunde wird in der Praxis derzeit ein Umrichter auf einer Hochseeplattform untergebracht, die in der Nähe des Windparks im Meer aufgestellt wird. Dieser seeseitige Umrichter ist über ein Wechselspannungsnetz mit dem Windpark verbunden, wobei sich eine Gleichspannungsverbindung von seinem Gleichspannungsanschluss zu einem landseitigen Umrichter erstreckt. Die Umrichter ermöglichen eine Leistungsübertragung in beiden Richtungen. Zum Anfahren des Windparks wird durch den seeseitigen Umrichter ein Gleichspannungsnetz erzeugt, wobei die dafür notwendige Versorgungsenergie dem landseitigen Energieversorgungsnetz entnommen werden kann. Die Windenergieanlagen des Windparks können sich daher leicht auf das bestehende Wechselspannungsnetz auf synchronisieren. Bei stärkeren Winden erfolgt die gewünschte Leistungsflussumkehr, nämlich die Leistungsübertragung von dem Windpark zum landseitigen Energieversorgungsnetz. Derzeit werden als Umrichter spannungseinprägende und selbstgeführte Umrichter (VSCs) und insbesondere Mehrstufenumrichter eingesetzt. Das Aufstellen solcher Umrichter im Meer ist jedoch aufgrund des immer noch hohen Gewichts der Umrichter kostenintensiv.

Daher wurde bereits vorgeschlagen, anstelle eines selbstgeführten Umrichters einen Diodengleichrichter seeseitig einzusetzen, der lediglich passive Leistungshalbleiter in Gestalt von Dioden aufweist. Ein solcher Diodenumrichter ermöglicht den Leistungstransport zwar in nur einer Richtung. Er weist jedoch den Vorteil auf, dass Verluste und das Gewicht im Vergleich mit einem selbstgeführten Umrichter deutlich herabgesetzt sind. Darüber hinaus sind kompakte Leistungshalbleiter einsetzbar.

Der Diodengleichrichter gibt ein festes Übersetzungsverhältnis zwischen der Gleich- und Wechselspannung an seinen Anschlüssen vor. Darüber hinaus erzeugt ein Diodengleichrichter Oberschwingungen sowohl an seiner Wechselspannungs- als auch an seiner Gleichspannungsseite. Aus diesem Grunde ist der eingangs genannte Transformator zwingend erforderlich. Dieses Bauteil macht die eingangs genannte Umrichterstation jedoch schwer und raumgreifend, so dass insbesondere bei einem Einsatz auf dem Meer hohe Herstellungskosten entstehen.

Zweckmäßigerweise sind Energieversorgungsmittel zur Versorgung eines an die Umrichterstation angeschlossenen Wechselspannungsnetzes vorgesehen. Die Energieversorgungsmittel werden dem Umstand gerecht, dass ein als Diodengleichrichter ausgestalteter Umrichter einen Leistungsfluss in nur einer Richtung erlaubt. Im Falle einer Windparkanbindung, wofür sich die erfindungsgemäße Umrichterstation insbesondere eignet, ist es jedoch oftmals erforderlich, das an die Umrichterstation angeschlossene Wechselspannungsnetz mit elektrischer Leistung zu versorgen. Mit Hilfe dieser elektrischen Energie können beispielsweise die Windenergieanlagen des Windparks ausgerichtet und die Rotorblätter um den jeweils erforderlichen Winkel verstellt werden. Die Energieversorgungsmittel umfassen beispielsweise einen Dieselmotor, der einen Generator antreibt, wobei der Generator die benötigte elektrische Leistung erzeugt, die in das mit dem Windpark verbundene Wechselspannungsnetz eingespeist wird. Vorteilhafterweise sind die Energieversorgungsmittel jedoch so ausgestaltet, dass auf einen Dieselmotor verzichtet werden kann, da der Dieselmotor wartungsintensiv ist und ständig mit Diesel versorgt werden muss. Insbesondere bei einer meerseitigen Aufstellung der erfindungsgemäßen Umrichterstation ist die Kraftstoff Versorgung bei Wind und Wetter beschwerlich. Aus diesem Grunde ist es im Rahmen der Erfindung zweckmäßig, Energieversorgungsmittel bereitzustellen, mit denen die Leistung von einem landseitigen Versorgungsnetz oder einem benachbarten meerseitigen Wechselspannungsnetz eingespeist werden kann. Solche Energieversorgungsmittel umfassen eine sich zumindest teilweise durch das Wasser erstreckende Energieversorgungsleitung, die z.B. eine Wechselspannungsleitung mit einer Spannung im Bereich von 50 bis 70 kV ist. Aufgabe der Erfindung ist es daher, eine Anordnung mit einer Umrichterstation der eingangs genannten Art bereitzustellen, wobei die Umrichterstation möglichst kompakt ist.

Diese Aufgabe wird gelöst durch eine Anordnung nach dem unabhängigen Patentanspruch.

Dabei ist wenigstens ein Kapselungsgehäuse vorgesehen, in dem zumindest ein Teil des Umrichters und zumindest ein Teil des Transformators gemeinsamen angeordnet sind, wobei das gemeinsame Kapselungsgehäuse mit dem Isolierstoff befüllt ist. Erfindungsgemäß ist vorgesehen nicht nur den Transformator in einem Isolierstoff anzuordnen, sondern auch den Umrichter. Der Begriff Isolierstoff soll im Rahmen der Erfindung alle Gase, Flüssigkeiten und Feststoffe umfassen, die gegenüber atmosphärischer Luft verbesserte Isolationseigenschaften aufweisen. Aufgrund der verbesserten Isolationseigenschaften können die einzelnen Komponenten des Umrichters, die auf einem unterschiedlich hohen elektrischen Potentialen liegen, mit weniger Abstand zueinander angeordnet werden, ohne dass es zu Spannungsüberschlägen kommt. Auch der Umrichter ist im Rahmen der Erfindung in einem Isolierstoff angeordnet. Lediglich im Wartungsfall muss der Isolierstoff entfernt werden. Hierzu sind z.B. an einem Kapselungsgehäuse, in dem der Umrichter angeordnet ist, Einlass- und Auslassmittel vorgesehen, über die der Isolierstoff entweichen beziehungsweise eingefüllt werden kann. Die erfindungsgemäße Umrichterstation kann beispielsweise einen Umrichter aufweisen, der eine Sechspuls-Brücke mit seinen Strom- oder Spannungsventilen ausbildet. Eine der Gleichspannungsklemmen der Sechs-Puls-Brücke ist z.B. mit dem Erdpotenzial verbunden. Die andere Gleichspannungsklemme ist dann beispielsweise über eine einpolige Gleichspannungsverbindung mit einem landseitigen Umrichter verbunden. Auch ist es möglich, eine aus der Hochspannungsgleichstromübertragung bekannte 12-Puls-Brücke auszugestalten. Die 12-Puls-Brücke verfügt über zwei Sechs-Puls-Brücken, die gleichspannungsseitig in Reihe geschaltet sind. Ihr Verbindungspunkt liegt in der Regel auf Erdpotenzial. Jede Sechs-Puls-Brücke ist über einen separaten Transformator an ein Wechselspannungsnetz angeschlossen. Die Wicklungen der beiden Transformatoren sind unterschiedlich miteinander verbunden, so dass eine unterschiedliche Phasenverschiebung an den Transformatoren erfolgt. Selbstverständlich kann die Umrichterstation auch zwei Sechspuls-Brücken aufweisen, die mit einer Klemme auf Erdpotenzial liegen.

Erfindungsgemäß ist wenigstens ein Kapselungsgehäuse vorgesehen, in dem zumindest ein Teil des Umrichters und zumindest ein Teil des Transformators gemeinsamen angeordnet sind. Beide Bauteile sind in dem gleichen Isolierstoff angeordnet. In dem Kapselungsgehäuse sind selbstverständlich auch das gegebenenfalls Beschaltungsnetzwerk des Umrichters untergebracht. Das Kapselungsgehäuse liegt zweckmäßigerweise auf Erdpotenzial.

Bei einem Einsatz der Umrichterstation zur Windparkanbindung kann es vorteilhaft sein, wenn der oder die Transformatoren und der Umrichter auf unterschiedlichen Fundamenten angeordnet sind.

Vorteilhafterweise ist wenigstens eine Glättungsdrossel vorgesehen ist, die mit dem Gleichspannungsanschluss des Umrichters verbundenen ist. Die Glättungsdrossel unterdrückt harmonische Oberschwingungen auf der Gleichspannungsseite und sorgt so für eine Glättung des Gleichstroms.

Vorteilhafterweise ist zumindest ein Teil der Glättungsdrossel in dem Kapselungsgehäuse angeordnet. Demgemäß sind der Umrichter, der Transformator und die Glättungsdrossel in dem gleichen Isolierstoff angeordnet.

Gemäß einer bevorzugten Ausgestaltung der Erfindung sind der Umrichter und der Transformator und bei Bedarf eine Glättungsdrossel jeweils in einem Kapselungsgehäuse angeordnet, wobei die Kapselungsgehäuse miteinander verbunden sind. Auf diese Weise können die besagten Bauteile elektrisch miteinander verschaltet werden, ohne dass aufwändige Durchführungen eingesetzt werden müssen, die einen auf einem Hochspannungspotential liegenden Leiter von der einen Isolierstoffumgebung in eine andere Isolierstoffumgebung oder in eine Luftatmosphäre überführen. Die in der Regel auf Erdpotenzial liegende Kapselung der Bauteile der Umrichterstation schützt diese darüber hinaus vor schädlichen Umwelteinflüssen, die insbesondere bei einer Aufstellung der Umrichterstation im Meer oder in einem See für Schäden sorgen können.

Der Isolierstoff kann grundsätzlich gasförmig, flüssig oder auch ein Feststoff sein. Zweckmäßigerweise werden die in der Energieübertragung und -verteilung bekannten Schutzgase, wie Schwefelhexafluorid oder der gleichen, eingesetzt. Besondere Vorteile ergeben sich jedoch, wenn als Isolierstoff eine Flüssigkeit, wie beispielsweise ein zweckmäßiges Isolieröl eingesetzt wird. Das Öl stellt neben der Isolierung auch eine Kühlung bereit. Darüber hinaus ist es im Rahmen der Erfindung zweckmäßig, dass Kühlmittel zum Kühlen des Isolierstoffs vorgesehen sind. Die Kühlmittel sind in oder an dem Kapselungsgehäuse angeordnet.

Zweckmäßigerweise ist der Umrichter ein Thyristor-Gleichrichter oder ein Diodengleichrichter ist. Insbesondere ergeben sich im Rahmen der Erfindung Vorteile, wenn der Umrichter ein Diodengleichrichter ist. Der Diodengleichrichter weist ausschließlich passive also nicht ansteuerbare Leistungshalbleiter auf, die leicht sind und wenig Verluste verursachen.

Zweckmäßigerweise weist der Umrichter mehrere gleichspannungsseitig in Reihe oder parallel geschaltete Teilumrichter auf. Mit Hilfe dieser Teilumrichter ist der Umrichter einfach skalierbar und kann somit leicht an die jeweils vorliegenden Strom- bzw. Spannungserfordernisse angepasst werden. Auch hier ist es im Rahmen der Erfindung besonders vorteilhaft, wenn die Teilumrichter Teildiondengleichrichter sind, die jeweils ausschließlich aus nicht ansteuerbaren Leistungshalbleitern in Gestalt von Dioden bestehen.

Gemäß einer diesbezüglich zweckmäßigen Weiterentwicklung ist jeder Teilumrichter wechselspannungsseitig mit einem Teiltransformator verbunden, wobei der besagte Teilumrichter und der besagte Teiltransformator in einem gemeinsamen Teilkapselungsgehäuse angeordnet sind. Gemäß dieser vorteilhaften Weiterentwicklung können Bauteile erzeugt werden, die sich beispielsweise einem Strang eines Windparks zugeordnet sind, wobei Windenergieanlagen an den Strang angeschlossen sind. Das Teilkapselungsgehäuse kann auf einfache Art und Weise, beispielsweise auf dem Fundament einer Windenergieanlage, im Meer aufgeständert werden. Die Umrichterstation kann somit verteilt im Meer oder in einem See angeordnet sein, wodurch sich die Aufstellung und somit die Kosten noch weiter reduzieren lassen.

Vorteilhafterweise sind in dem Teilkapselungsgehäuse eine Teilglättungsdrossel angeordnet. Die Teilglättungsdrossel ist gleichspannungsseitig an den Teilumrichter angeschlossen. Hierbei ist es zweckmäßig, dass der Teilumrichter ein Teildiodengleichrichter ist.

Zweckmäßigerweise weist jeder Teilumrichter zwei Gleichspannungsklemmen auf, die mittels eines Überbrückungsschalters überbrückbar sind. Gemäß dieser vorteilhaften Weiterentwicklung kann, beispielsweise im Fehlerfall, eine Teilumrichterstation, die beispielsweise einen Teildiodengleichrichter, einen Teiltransformator und eine Teilglättungsdrossel umfasst, überbrückt werden. Ist die Teilumrichterstation mit einem Abschnitt eines Windparks, beispielsweise mit einem Strang eines Windparks, verbunden, kann auf diese Weise auch der besagte Abschnitt überbrückt werden. Dies ist vorteilhaft, da der Fehler sowohl im jeweiligen Bauteil als auch in dem Strang oder Zweig des mit dem Bauteil verbundenen Wechselspannungsnetzes vorliegen kann.

Zweckmäßigerweise ist wechselspannungsseitig des Umrichters eine Filtereinheit vorgesehen. Die Filtereinheit dient zur Blindleistungskompensation und zum Herausfiltern von harmonischen Oberschwingungen der Grundschwingung, die beim Normalbetrieb des Diodengleichrichters entstehen. Die Filtereinheit kann auch Windenergieanlagen umfassen oder ausschließlich aus Windenergieanlagen bestehen.

Gemäß einer hiervon abweichenden Ausgestaltung der Erfindung umfassen die Energieversorgungsmittel einen Teilumrichter, der Teildiodengleichrichtern eines Diodengleichrichters gleichspannungsseitig in Reihe geschaltet ist. Mit Hilfe des Teilumrichters ist es möglich, die Gleichspannungsverbindung, durch welche die Umrichterstation mit dem landseitigen Energieversorgungsnetz verbunden ist, auch die für die Bereitstellung des Leistungsflusses in entgegengesetzter Richtung, also von Land zu Windpark, zu nutzen. Hierbei ist es selbstverständlich zweckmäßig, wenn die Teildiodengleichrichter, wie zuvor erwähnt, mit einem Überbrückungsschalter ausgestattet sind, mit denen die Überbrückung der Teildiodengleichrichter in der Reihenschaltung ermöglicht ist, so dass die Leistung von einem landseitigen Umrichter über die Gleichspannungsverbindung bereitgestellt und von dem oder den Teilumrichtern in Wechselspannung umgewandelt werden kann. Die so erzeugte Wechselspannung dient dann zur Energieversorgung eines angeschlossenen Windparks.

Zweckmäßigerweise ist der Transformator mit einer Schaltanlage verbunden. Die Schaltanlage ist beispielsweise eine gasisolierte Schaltanlage, wobei eine entsprechende Durchführung zwischen der Schaltanlage und dem beispielsweise in Öl gelagerten Transformator vorgesehen ist. Wie bereits weiter oben erwähnt wurde, sind im Rahmen der Erfindung auch mehrere Transformatoren einsetzbar. Dies gilt auch für die Schaltanlage.

Zweckmäßigerweise ist die Schaltanlage über eine Wechselspannungsleitung mit einem Einkoppelbauteil verbindbar, das an ein landseitiges Energieversorgungsnetz oder ein seeseitiges Wechselspannungsnetz angeschlossen ist.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkende Bauteile verweisen und wobei
- Figur 1: ein Ausführungsbeispiel der erfindungsgemäßen Umrichterstation,
- Figur 1a: den Diodengleichrichter gemäß Figur 1 im Detail,
- Figur 2: ein weiteres Ausführungsbeispiel einer erfindungsgemäßen Umrichterstation, die einen meerseitig angeordneten Windpark mit einem landseitigen Umrichter verbindet,
- Figur 3: ein Ausführungsbeispiel einer Teilumrichterstation mit Teildiodengleichrichter, Teilglättungsdrossel und Teiltransformator in einem gemeinsamen Kapselungsgehäuse,
- Figur 4: ein Ausführungsbeispiel eines Teilumrichters mit einem Teiltransformator und
- Figur 5: die Teilumrichterstation gemäß Figur 3 in einer Seitenansicht schematisch verdeutlichen.

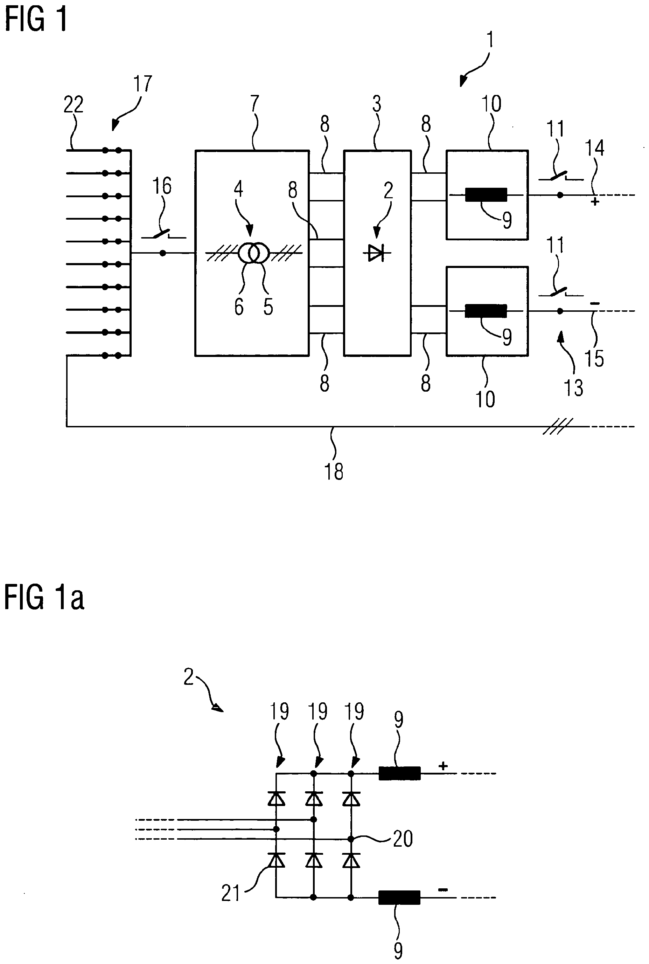

Figur 1 zeigt ein Ausführungsbeispiel der erfindungsgemäßen Umrichterstation 1, die einen Diodengleichrichter 2 aufweist, der in einem Kapselungsgehäuse 3 angeordnet ist, das mit einem Isolierstoff befüllt ist. Der Isolierstoff ist in dem in Figur 1 gezeigten Ausführungsbeispiel ein Isolieröl. Darüber hinaus umfasst die Umrichterstation 1 einen Transformator 4, der eine Primärwicklung 5 sowie eine Sekundärwicklung 6 aufweist, die induktiv miteinander gekoppelt sind. Der Transformator 4 ist in einem Kapselungsgehäuse 7 angeordnet, das mit dem gleichen Isolieröl befüllt ist. Zum Durchführen der Phasenleiter der wechselspannungsseitigen Verbindung zwischen Transformator 4 und Umrichter 2 dienen hohlzylindrische Zuführungsrohre 8, die ebenfalls mit dem Isolieröl befüllt sind. Die Kapselungsgehäuse 3, 7 liegen auf Erdpotenzial.

Die Umrichterstation 1 verfügt darüber hinaus über zwei Glättungsdrosseln 9, die jeweils mit einem der beiden Gleichspannungsanschlüsse des Diodengleichrichters 2 verbunden sind. Jede Gleichspannungsdrossel 9 ist in einem separaten Kapselungsgehäuse 10 angeordnet, das ebenfalls mit dem besagten Isolieröl befüllt ist und auf Erdpotenzial liegt. Zum Durchführen der Gleichspannungsleitungen zwischen Glättungsdrossel 9 und dem jeweiligen Gleichspannungsanschluss des Diodengleichrichters 2 dienen wieder Zuführungsrohre 8. Ferner sind mechanische Schalter 11 vorgesehen, mit denen die Umrichterstation 1 an eine Gleichspannungsverbindung 13 mit den beiden Gleichspannungspolen 14 und 15 angeschlossen werden kann. Der Transformator 4 ist über einen Wechselspannungsleiter 16 mit einer mehrere dreipolige Schalter aufweisende Schaltanlage 17 verbunden, die als gasisolierte Hochspannungsschaltanlage 17 realisiert ist. Einer der Schalter der Schaltanlage 17 ist mit einer Wechselspannungsleitung 18 verbunden, die als Teil von Energieversorgungsmitteln mit einem landseitigen Einkoppelbauteil verbunden ist, das zur Einspeisung einer elektrischen Leistung in die Wechselspannungsleitung 18 dient. Das Einkoppelbauteil ist z.B. ein Transformator. Die Schaltanlage 17 ist an verschiedene Stränge 22 eines Wechselspannungsnetzes angeschlossen, wobei an jedem Strang 22 mehrere Windenergieanlagen angeschlossen sind. Da die elektrische Leistung mit Hilfe des Diodengleichrichters 2 nur vom Windpark zum Land übertragen werden kann, muss die Energieübertragung in die andere Richtung über die Wechselspannungsleitung 18 erfolgen. Diese weist eine hierfür zweckmäßige Wechselspannung zwischen 50 und 70 kV auf.

Wie aus Figur 1 erkennbar ist, sind der Transformator 4, der Diodengleichrichter 2 und die Glättungsdrossel 9 in dem gleichen Isoliermedium oder Isolierstoff, hier in Öl, angeordnet, so dass die Umrichterstation 1 kompakter gebaut werden kann. Die Kapselungsgehäuse 3, 7, 10 sind alle miteinander verbunden. Statt aufwändiger Durchführungen werden im Rahmen der Erfindung Zuführungsrohre 8 eingesetzt, die ebenfalls mit Isolieröl befüllt sind und durch die sich der jeweilige Hochspannungsleiter mittig erstreckt.

Der Aufbau des Diodengleichrichters 2 ist in Figur 1a genauer verdeutlicht. Es ist erkennbar, dass der Diodengleichrichter 2 drei Phasenmodule 19 aufweist, deren Anzahl der Anzahl der Phasen des Wechselspannungsnetzes entspricht, mit dem der Transformator 4 verbunden ist. Jedes Phasenmodul 19 weist zwei entgegengesetzt zueinander polarisierbare Gleichspannungsanschlüsse oder Gleichspannungsklemmen auf, die mit einem Plus- und Minuszeichen gekennzeichnet sind. Darüber hinaus verfügt jedes Phasenmodul 19 über einen Wechselspannungsanschluss 20. Zwischen dem Wechselspannungsanschluss 20 und jedem der Gleichspannungsanschlüsse erstreckt sich jeweils ein Diodenventil 21, so dass jedes Phasenmodul 19 über zwei Diodenventile 21 verfügt. Die Diodenventile 21 umfassen eine Reihenschaltung von Dioden, deren Anzahl jeweils von der vorliegenden Spannung abhängig ist. Gleichspannungsseitig des Diodengleichrichters sind die Glättungsdrosseln 9 schematisch und ohne Kapselungsgehäuse dargestellt.

Der in Figur 1a dargestellte Diodengleichrichter bildet eine so genannte Sechspuls-Brücke aus, die dem Fachmann im Bereich der Hochspannungsgleichstromübertragung bestens bekannt ist. An dieser Stelle sei jedoch darauf hingewiesen, dass der Diodengleichrichter 2 auch zwei solcher Sechspuls-Brücken aufweisen kann, die gleichspannungsseitig miteinander verbunden und über unterschiedliche Transformatoren mit dem gleichen oder mit unterschiedlichen Abschnitten oder Strängen 22 eines Wechselspannungsnetzes verbunden sind. Die Transformatoren bewirken einen unterschiedlichen Phasenversatz der von ihnen übertragenen Wechselspannung, so dass eine als solche ebenfalls bekannte 12-Puls-Brücke bereitgestellt ist. Die Verbindungsleitung der beiden Sechspulsbrücken ist zweckmäßigerweise geerdet. Natürlich kann jede der beiden Sechspulsbrücken auch unabhängig von der anderen Sechspulsbrücke an einer ihrer Gleichspannungsklemmen geerdet sein. Auch wenn der Diodengleichrichter nur eine Sechspulsbrücke ausbildet, kann diese an einer Gleichspannungsklemme mit dem Erdpotential verbunden sein, so dass ein so genannter Monopol ausgebildet ist.

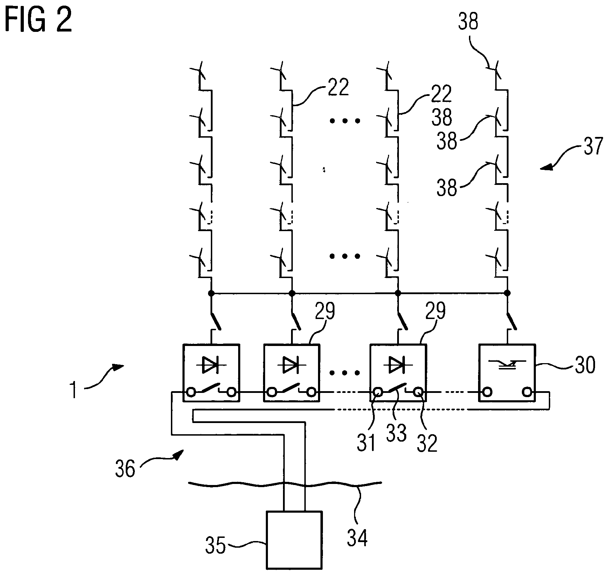

Figur 2 zeigt ein weiteres Ausführungsbeispiel der erfindungsgemäßen Umrichterstation 1, die aus Teilumrichterstationen 29 zusammengesetzt ist, wobei jede Teilumrichterstation 29 einen figürlich nicht dargestellten Teiltransformator sowie eine figürlich ebenfalls nicht dargestellte Teilglättungsdrossel aufweist. Die Teilumrichterstationen 29 sind gleichspannungsseitig miteinander in Reihe geschaltet. Darüber hinaus ist in der besagten Reihenschaltung ein Teilumrichter 30 erkennbar. Jede Teilumrichterstation 29 weist eine erste Gleichspannungsanschlussklemme 31 sowie eine zweite Gleichspannungsanschlussklemme 32 auf, die mittels eines Überbrückungsschalters 33 miteinander verbunden werden können. Mit Hilfe des Überbrückungsschalters 33 ist somit eine Überbrückung beispielsweise einer fehlerhaften Teilumrichterstation 29 ermöglicht.

Die Umrichterstation 1 ist auf einer figürlich nicht dargestellten Hochseeplattform etwa 100 km vor einer Küste 34 im Meer angeordnet, wobei ein landseitiger Umrichter 35 über eine Gleichspannungsverbindung 36 mit der Umrichterstation 1 verbunden ist. Es ist erkennbar, dass jede Teilumrichterstation 29 mit einem Strang 22 eines Windparks 37 verbunden ist, wobei der Windpark 37 aus einer Vielzahl von Windenergieanlagen 38 besteht.

Auch bei Windstille benötigt der Windpark 37 Energie. Diese wird ihm dann mit Hilfe des Teilumrichters 30 zur Verfügung gestellt. Hierzu werden z.B. alle Teildiodengleichrichter 29 durch Schließen des jeweiligen Überbrückungsschalters 33 überbrückt, so dass der Teilumrichter 30 direkt mit dem landseitigen Umrichter 35 verbunden ist, der beispielsweise ein modularer Mehrstufenumrichter ist. Dieser ist mit einem figürlich nicht dargestellten Energieversorgungsnetz verbunden und speist die notwendige Leistung in den Teilumrichter 30 ein, der diese wechselspannungsseitig für den Windpark 37 bereitstellt.

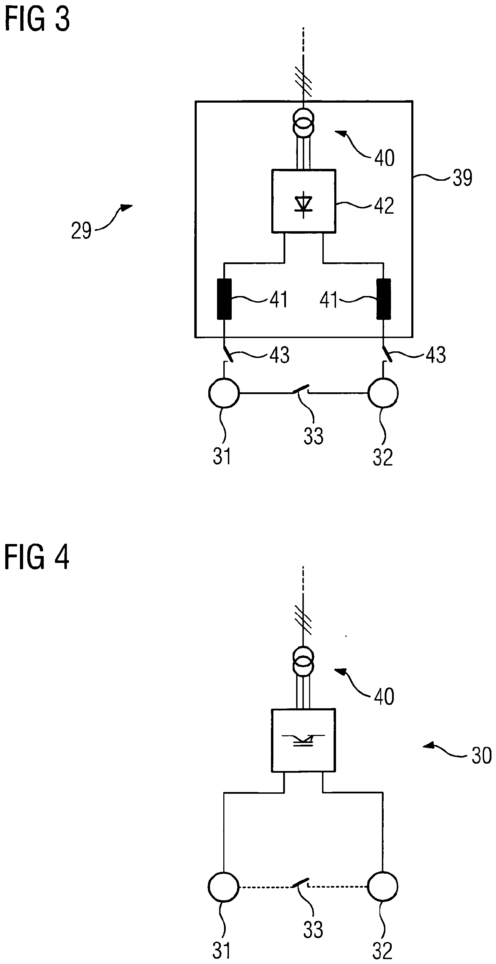

Figur 3 zeigt die Teilumrichterstation 29 genauer. Es ist erkennbar, dass die Teilumrichterstation 29 ein Teilkapselungsgehäuse 39 aufweist, in dem zwei Teilglättungsdrosseln 41, ein Teildiodengleichrichter 42 sowie ein Teiltransformator 40 gemeinsam angeordnet sind. Das Teilkapselungsgehäuse 39 ist mit Isolieröl befüllt. Außerhalb des Teilkapselungsgehäuses 39 sind mechanische Gleichspannungsschalter 43 erkennbar, mit denen der jeweilige Pol mit dem Überbrückungsschalter 33 verbindbar ist.

Figur 4 zeigt den Teilumrichter 30 genauer, der in keinem separaten Kapselungsgehäuse angeordnet ist. Der Teilumrichter 30 weist gleichspannungsseitig keine Glättungsdrosseln auf. Diese sind bei einem gesteuerten oder selbstgeführten Teilumrichter unnötig. Auch der Teilumrichter 30 ist mit Hilfe eines Überbrückungsschalters 33 gleichspannungsseitig überbrückbar.

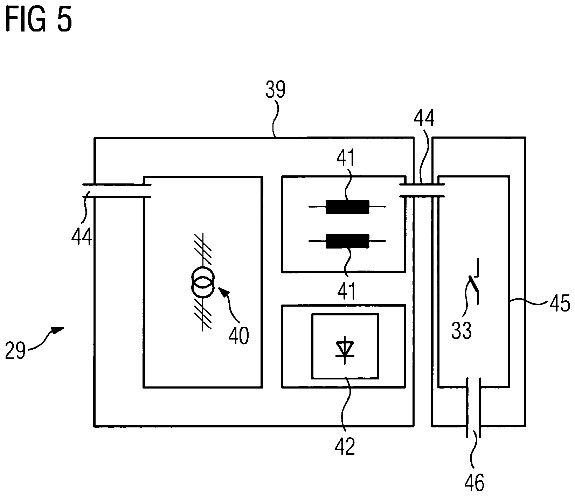

Figur 5 zeigt die Teilumrichterstation 29 in einer schematischen Seitenansicht. Es ist erkennbar, dass Teiltransformator 40, die Teilglättungsdrosseln 41 sowie der Teildiodengleichrichter 42 in einem gemeinsamen Kapselungsgehäuse 39 angeordnet sind, das mit Öl befüllt ist. Weiterhin sind Durchführungen 44 erkennbar, mit denen Hochspannungsleiter von einer Ölisolierung in eine Schutzgasisolierung überführt sind, wobei sie sich durch eine oder mehrere auf Erdpotenzial liegende Wandung des jeweiligen Kapselungsgehäuses erstrecken. Darüber hinaus ist erkennbar, dass der Überbrückungsschalter 33 ebenfalls in einem Kapselungsgehäuse 45 angeordnet ist, das jedoch mit einem Schutzgas, hier Schwefelhexafluorid, befüllt ist. Die Durchführung 46 ermöglicht einen Kabelanschluss an das mit Schutzgas befüllte Gehäuse 45.

## Patentansprüche

1. Anordnung mit einer meerseitig aufgestellten Umrichterstation (1) zum Übertragen elektrischer Leistung, mit einer Schaltanlage und mit Energieversorgungsmitteln (18,30) zur Versorgung eines an die Umrichterstation angeschlossenen Wechselspannungsnetzes (22) mit elektrischer Leistung aus einem landseitigen Energieversorgungsnetz oder aus einem benachbarten meerseitigen Wechselspannungsnetz, wobei an verschiedene Stränge des Wechselspannungsnetzes jeweils mehrere Windenergieanlagen angeschlossen sind,
- wobei die Umrichterstation einen Umrichter (2), der einen Gleichspannungsanschluss und einen Wechselspannungsanschluss aufweist, und wenigstens einen Transformator (4) aufweist, wobei der Transformator mit dem Wechselspannungsanschluss verbundenen ist, wobei der Transformator und der Umrichter (2) in einem Isolierstoff angeordnet sind, wobei wenigstens ein Kapselungsgehäuse vorgesehen ist, in dem zumindest ein Teil des Umrichters (2) und zumindest ein Teil des Transformators (4) gemeinsamen angeordnet sind, wobei das gemeinsame Kapselungsgehäuse mit dem Isolierstoff befüllt ist, und
- wobei der Umrichter (2) mehrere gleichspannungsseitig in Reihe geschaltete Teildiodengleichrichter (42) aufweist, wobei die Teildiodengleichrichter mit einem Überbrückungsschalter ausgestattet sind, und die Energieversorgungsmittel einen gesteuerten oder selbstgeführten Teilumrichter (30) aufweisen, der den Teildiodengleichrichtern (42) gleichspannungsseitig in Reihe geschaltet ist, oder
wobei die Energieversorgungsmittel eine sich zumindest teilweise durch Wasser erstreckende Energieversorgungsleitung in Form einer Wechselspannungsleitung (18) umfassen, wobei der Transformator (4) mit der Schaltanlage (17) verbunden ist, die über die Wechselspannungsleitung (18) mit einem Einkoppelbauteil verbunden ist, das an das landseitige Energieversorgungsnetz oder das meerseitige Wechselspannungsnetz angeschlossen ist.

2. Anordnung nach Anspruch 1,
**dadurch gekennzeichnet, dass**
wenigstens eine Glättungsdrossel (9) vorgesehen ist, die mit dem Gleichspannungsanschluss verbundenen ist.

3. Anordnung nach Anspruch 2,
**dadurch gekennzeichnet, dass**
zumindest ein Teil der Glättungsdrossel (9) in dem Kapselungsgehäuse (3,7,10) angeordnet ist.

4. Anordnung nach einem der vorhergehenden Ansprüche,
**dadurch gekennzeichnet, dass**
der Isolierstoff ein Schutzgas oder eine Isolierflüssigkeit ist.

5. Anordnung nach einem der vorhergehenden Ansprüche,
**dadurch gekennzeichnet, dass**
der Umrichter ein Thyristror-Gleichrichter oder ein Diodengleichrichter ist.

6. Anordnung nach einem der vorhergehenden Ansprüche,
**dadurch gekennzeichnet, dass**
jeder Teildiodengleichrichter (42) wechselspannungsseitig mit einem Teiltransformator (40) verbunden ist, wobei der besagte Teildiodengleichrichter (42) und der besagte Teiltransformator (40) in einem gemeinsamen Teilkapselungsgehäuse (39) angeordnet sind.

7. Anordnung nach Anspruch 6,
**dadurch gekennzeichnet, dass**
in dem Teilkapselungsgehäuse eine Teilglättungsdrossel (41) angeordnet ist.

8. Anordnung nach einem der vorhergehenden Ansprüche,
**dadurch gekennzeichnet, dass**
jeder Teildiodengleichrichter (42) zwei Gleichspannungsklemmen (31,32) aufweist, die mittels eines Überbrückungsschalters (33) überbrückbar sind.

9. Anordnung nach einem der vorhergehenden Ansprüche,
**dadurch gekennzeichnet, dass** wechselspannungsseitig des Umrichters (2) eine Filtereinheit vorgesehen ist.

## Claims

1. Arrangement having a converter station (1), which is situated in the sea, for transmitting electrical power, having a switchgear assembly and having power supply means (18, 30) for supplying electrical power from a power supply grid on land or from a neighbouring AC-voltage grid in the sea to an AC-voltage grid (22) which is connected to the converter station, wherein a plurality of wind power installations are respectively connected to various strings of the AC-voltage grid,
- wherein the converter station comprises a converter (2), which has a DC-voltage connection and an AC-voltage connection, and at least one transformer (4), wherein the transformer is connected to the AC-voltage connection, wherein the transformer and the converter (2) are arranged in an insulating material, wherein at least one encapsulation housing is provided in which at least a part of the converter (2) and at least a part of the transformer (4) are arranged together, wherein the common encapsulation housing is filled with the insulating material, and
- wherein the converter (2) has a plurality of partial diode rectifiers (42) which are connected in series on the DC-voltage-side, wherein the partial diode rectifiers are provided with a bypass switch, and the power supply means comprise a controlled or self-commutated partial converter (30) which is connected in series on the DC-voltage-side with the partial diode rectifiers (42), or
wherein the power supply means comprise a power supply line in the form of an AC-voltage line (18) which extends at least in part through water, wherein the transformer (4) is connected to the switchgear assembly (17) which is connected via the AC-voltage line (18) to a coupling-in component which is connected to the power supply grid on land or to the AC-voltage grid in the sea.

2. Arrangement according to Claim 1,
**characterized in that**
at least one smoothing inductor (9) is provided and is connected to the DC-voltage connection.

3. Arrangement according to Claim 2,
**characterized in that**
at least a part of the smoothing inductor (9) is arranged in the encapsulation housing (3, 7, 10).

4. Arrangement according to any of the preceding claims, **characterized in that**
the insulating material is a protective gas or an insulating liquid.

5. Arrangement according to any of the preceding claims, **characterized in that**
the converter is a thyristor rectifier or a diode rectifier.

6. Arrangement according to any of the preceding claims, **characterized in that**
each partial diode rectifier (42) is connected on the AC-voltage-side to a partial transformer (40), wherein said partial diode rectifier (42) and said partial transformer (40) are arranged in a common partial encapsulation housing (39).

7. Arrangement according to Claim 6,
**characterized in that**
a partial smoothing inductor (41) is arranged in the partial encapsulation housing.

8. Arrangement according to any of the preceding claims, **characterized in that**
each partial diode rectifier (42) has two DC-voltage terminals (31, 32) which can be bypassed by means of a bypass switch (33) .

9. Arrangement according to any of the preceding claims, **characterized in that**
a filter unit is provided on the AC-voltage-side of the converter (2).

## Revendications

1. Implantation comprenant un poste (1) de convertisseur, érigé en mer, de transport de puissance électrique, comprenant une installation de distribution et comprenant des moyens (18, 30) d'alimentation en énergie pour l'alimentation en puissance électrique d'un réseau (22) à tension alternative, raccordé au poste de convertisseur, à partir d'un réseau d'alimentation en énergie sur la terre ferme ou d'un réseau à tension alternative voisin en mer, dans laquelle respectivement plusieurs éoliennes sont connectées à diverses branches du réseau à tension alternative,
- dans laquelle le poste de convertisseur a au moins un transformateur (4) et un convertisseur (2), qui a une borne de tension continue et une borne de tension alternative, dans laquelle le transformateur est connecté à la borne de tension alternative, dans laquelle le transformateur et le convertisseur (2) sont disposés dans une matière isolante, dans laquelle il est prévu au moins un boîtier de blindage, dans lequel au moins une partie du convertisseur (2) et au moins une partie du transformateur (4) sont disposées conjointement, dans laquelle le boîtier commun de blindage est rempli de la matière isolante, et
- dans laquelle le convertisseur (2) a plusieurs redresseurs (42) à diodes partiels montés en série du côté de la tension continue, dans laquelle les redresseurs à diodes partiels sont équipés d'un interrupteur de shuntage, et les moyens d'alimentation en énergie ont un convertisseur (30) partiel commandé ou à commutation autonome, qui est monté en série du côté de la tension continue avec les redresseurs (42) à diodes partiels, ou
dans laquelle les moyens d'alimentation en énergie comprennent, sous la forme d'une ligne (18) à tension alternative, une ligne d'alimentation en énergie s'étendant au moins en partie dans l'eau, dans laquelle le transformateur (4) est connecté à l'installation (17) de distribution, qui est, par l'intermédiaire de la ligne (18) à tension alternative, connectée à une pièce d'injection, qui est raccordée au réseau d'alimentation en énergie sur la terre ferme ou au réseau à tension alternative en mer.

2. Implantation suivant la revendication 1,
**caractérisée en ce qu'**
il est prévu au moins une bobine (9) de lissage, qui est connectée à la borne de tension continue.

3. Implantation suivant la revendication 2,
**caractérisée en ce qu'**
au moins une partie de la bobine (9) de lissage est disposée dans le boîtier (3, 7, 10) de blindage.

4. Implantation suivant l'une des revendications précédentes, **caractérisée en ce que**
la matière isolante est un gaz de protection ou un liquide isolant.

5. Implantation suivant l'une des revendications précédentes, **caractérisée en ce que**
le convertisseur est un redresseur à thyristor ou un redresseur à diode.

6. Implantation suivant l'une des revendications précédentes, **caractérisée en ce que**
chaque redresseur (42) à diode partiel est connecté du côté de la tension alternative à un transformateur (40) partiel, ledit redresseur (42) à diode partiel et ledit transformateur (40) partiel étant disposés dans un boîtier (39) partiel de blindage commun.

7. Implantation suivant la revendication 6,
**caractérisée en ce qu'**
une bobine (41) partielle de lissage est disposée dans le boîtier partiel de blindage.

8. Implantation suivant l'une des revendications précédentes, **caractérisée en ce que**
chaque redresseur (42) à diode partiel a deux bornes (31, 32) de tension continue, qui peuvent être shuntées au moyen d'un interrupteur (33) de shuntage.

9. Implantation suivant l'une des revendications précédentes, **caractérisée en ce qu'**
il est prévu une unité de filtrage du côté de la tension alternative du convertisseur (2).
